(19) **Europäisches Patentamt**

**European Patent Office**

**Office européen des brevets**

(11) **EP 0 715 172 B1**

(12) **FASCICULE DE BREVET EUROPEEN**

(45) Date de publication et mention
de la délivrance du brevet:
**06.04.2005 Bulletin 2005/14**

(51) Int Cl.⁷: **G01R 27/18**, G01R 31/04

(21) Numéro de dépôt: **95402695.1**

(22) Date de dépôt: **30.11.1995**

(54) **Appareil de contrôle pour socle de prise de courant à contact de terre**

Testgerät für geerdete Wandsteckdose

Testing device for earthed wall socket

(84) Etats contractants désignés:
**BE ES IT PT**

(30) Priorité: **01.12.1994 FR 9414436**

(43) Date de publication de la demande:
**05.06.1996 Bulletin 1996/23**

(73) Titulaire: **SOCIETE ANONYME DES ETS CATU**
**F-92222 Bagneux (FR)**

(72) Inventeurs:
• **Mermoud, Marc**
**F-91370 Verrieres le Buisson (FR)**
• **Bouchez, Bernard**
**F-92220 Bagneux (FR)**

(74) Mandataire: **Santarelli**
**14, avenue de la Grande Armée,**
**B.P. 237**
**75822 Paris Cedex 17 (FR)**

(56) Documents cités:
**AU-B- 617 082**          **DE-A- 3 421 829**
**DE-A- 3 429 067**          **US-A- 5 051 732**

• **LE JOURNAL DE L'EQUIPEMENT ELECTRIQUE ET ELECTRONIQUE, no. 477, Mars 1982 PARIS, FRANCE, pages 49-50, 'LA MESURE DES COURANTS DE COURT-CIRCUIT...'**

## Description

La présente invention concerne d'une manière générale le contrôle de conformité d'une quelconque installation électrique comportant des socles de prise de courant.

Elle vise plus particulièrement le cas où, suivant certaines dispositions normatives, un tel socle de prise de courant, qui constitue en pratique une partie fixe sur laquelle peut être branché par une fiche mobile un quelconque appareil électrique, comporte un contact de terre, en étant préférentiellement protégé en amont par un quelconque dispositif de protection différentielle.

Globalement, dans les installations électriques les plus classiques, un tel socle de prise de courant comporte trois contacts, à savoir deux contacts de pôle et un contact de terre.

Les deux contacts de pôle sont usuellement des alvéoles, et l'un d'eux est relié à la phase du réseau de distribution électrique correspondant tandis que l'autre est relié au neutre de celui-ci.

Le contact de terre est usuellement soit une broche soit un ensemble de deux languettes disposées latéralement en positions diamétralement opposées l'une par rapport à l'autre, et il est relié à un conducteur, communément dit conducteur de protection, spécifiquement prévu à cet effet, qui est lui-même relié à la terre, et qui, dans certaines installations, est conjointement relié au neutre du réseau de distribution électrique.

Il est souhaitable de pouvoir contrôler que, pour un local donné, la résistance de terre correspondante est satisfaisante, ou, autrement dit, que, pour ce local, elle est suffisamment faible pour assurer la sécurité nécessaire, c'est-à-dire pour écouler à la terre les charges susceptibles d'être dangereuses pour l'usager dans le cas d'une fuite de courant.

Il suffira à ce sujet d'indiquer à titre d'exemple qu'une résistance de terre supérieure à 100 ohms est usuellement considérée comme trop importante dans les locaux secs, et que, par conséquent, dans les locaux humides, une résistance de terre encore inférieure doit a fortiori être respectée.

La présente invention a d'une manière générale pour objet un appareil de contrôle permettant, notamment, d'assurer très simplement et rapidement un contrôle de la résistance de terre.

Cet appareil de contrôle reprend certaines des dispositions de celui décrit dans la demande de brevet français qui, déposée le 23 octobre 1992 sous le No 92 12906, a été publiée sous le No 2 697 343.

Suivant ces dispositions, il est prévu, en combinaison, des organes de connexion, qui sont propres à un branchement de l'appareil sur les contacts de pôle et de terre d'un socle de prise de courant, des moyens de pontage, qui sont propres à établir temporairement une liaison entre celui de ces organes de connexion qui correspond au contact de pôle du socle de prise de courant relié à la phase et celui de ces organes de connexion qui correspond au contact de terre de ce socle de prise de courant, et un dispositif de contrôle, qui, sous l'action d'un organe de commande à la disposition de l'usager, est apte à envoyer une impulsion de contrôle à travers ces moyens de pontage.

En pratique, les organes de connexion de l'appareil sont des contacts complémentaires de ceux du socle de prise de courant et appartiennent conjointement à une fiche qui, solidaire du boîtier de celui-ci, en formant avec ce boîtier un ensemble monobloc, est propre à être embrochée sur ce socle de prise de courant.

L'appareil de contrôle mettant en oeuvre de telles dispositions permet avantageusement de tirer systématiquement des informations du seul fait de son embrochage dans un socle de prise de courant, et, à la différence d'un appareil de mesure, qui, avant tout relevé, exige usuellement de procéder à des vérifications, voire même à des étalonnages, sa mise en oeuvre ne nécessite avantageusement pas de personnel spécialisé.

Dans la demande de brevet français No 92 12906, l'impulsion de contrôle lancée entre phase et terre est une impulsion de défaut destinée à contrôler la capacité de déclenchement du dispositif de protection différentielle placé en amont.

Cette fonction de déclenchement du dispositif de protection différentielle donne par elle-même satisfaction, parce qu'elle permet de contrôler le fonctionnement effectif de celui-ci.

Mais elle n'est pas nécessairement souhaitable pour toutes les installations électriques, parce qu'elle entraîne momentanément une certaine perturbation de celles-ci.

L'appareil de contrôle suivant l'invention permet avantageusement, sous un premier aspect, de substituer à cette fonction de contrôle de la capacité de déclenchement du dispositif de protection différentielle un simple contrôle de la résistance de terre.

On connaît déjà par DE-A-34 21 829 un appareil mettant en oeuvre un tel contrôle de la résistance de terre, l'impulsion de contrôle émise par son dispositif de contrôle étant une impulsion de courant, ce dispositif de contrôle comportant, d'une part, des moyens de calcul, qui sont aptes à mesurer successivement la tension à vide et la tension en charge et à en déduire une valeur de résistance, et, d'autre part, des moyens de comparaison pour la desserte de moyens de signalisation aptes à émettre un signal sonore si la résistance ainsi calculée se situe dans une plage autorisée.

L'invention propose quant à elle un appareil de contrôle pour socle de prise de courant à contact de terre, du genre comportant des organes de connexion, qui sont propres à son branchement sur les contacts de pôle et de terre du socle de prise de courant à contrôler, des moyens de pontage, qui sont propres à établir une liaison entre celui de ces organes de connexion qui correspond au contact de pôle du socle de prise de courant relié à la phase et celui de ces organes de connexion qui correspond au contact de terre de celui-ci, et un dispositif de contrôle, qui, sous l'action d'un organe de commande à la disposition de l'usager, est apte à envoyer une impulsion de contrôle à travers lesdits moyens de pontage, caractérisé en ce que, l'impulsion de contrôle étant une impulsion de courant appliquée aux bornes des moyens de pontage, le dispositif de contrôle comporte, d'une part, des moyens de calcul, qui sont aptes à mesurer successivement la tension à vide et la tension en charge aux bornes des moyens de pontage et à en déduire une valeur de résistance, et, d'autre part, des moyens de comparaison qui, pour la desserte de moyens de signalisation, sont aptes à comparer la valeur de résistance ainsi calculée à plusieurs valeurs de résistance données précalibrées différentes, les moyens de signalisation comportant plusieurs organes de visualisation correspondant chacun respectivement à l'une desdites valeurs de résistance données précalibrées différentes.

Lorsque, comme dans la demande de brevet français n° 92 12906, et comme dans la présente invention, et contrairement à DE-A-34 21 829, l'impulsion de courant est appliquée aux bornes de moyens de pontage tandis que c'est aux bornes de tels moyens que sont mesurées les tensions à vide et en charge, il s'avère que la valeur de résistance ainsi calculée correspond à la résistance globale de la boucle de défaut qui, à travers, successivement, la filerie concernée, la résistance de terre du réseau de distribution électrique, et la résistance de terre recherchée, se referme sur les moyens de pontage de l'appareil de contrôle suivant l'invention.

A quelques ohms près, elle donne donc une valeur par excès de la résistance de terre recherchée, ce qui, conformément aux dispositions normatives en la matière, va avantageusement dans le sens de la sécurité.

A chaque contrôle, seul l'un de ces organes de visualisation est excité, et il donne par excès la résistance de terre recherchée.

Dans tous les cas, il est fait en sorte que l'impulsion de courant assurant le contrôle recherché ne provoque pas le déclenchement du dispositif de protection différentielle intervenant en amont du socle de prise de courant concerné.

Il suffit par exemple que cette impulsion de courant soit inférieure au seuil de déclenchement de ce dispositif de protection différentielle.

Il est par ailleurs important de pouvoir également contrôler qu'une quelconque masse métallique éventuellement présente dans un local, telle que par exemple une suspension, la grille de protection d'un luminaire, ou une huisserie, est elle aussi convenablement reliée à la terre.

Pour être en mesure d'assurer une telle fonction, l'appareil de contrôle suivant l'invention comporte, en outre, suivant un deuxième aspect, un organe de connexion auxiliaire, qui, propre au branchement d'une pointe de touche à appliquer à la masse métallique à contrôler, est relié à un circuit de contrôle de continuité de masse, avec, interposé sur ce circuit de contrôle de continuité de masse, un contact interrupteur piloté par un relais sur le circuit d'alimentation duquel est interposé un interrupteur contrôlé, et le circuit de base de cet interrupteur contrôlé comporte un ensemble intégrateur dont l'entrée est reliée à cet organe de connexion auxiliaire.

Appliquée à la masse métallique à contrôler, la pointe de touche permet de refermer sur celle-ci une boucle qui, par l'intermédiaire de la terre, comporte en série une partie du circuit de contrôle de continuité de masse.

Mais, ce circuit de contrôle de continuité de masse est mis hors service si une tension alternative est effectivement présente sur la masse métallique à contrôler.

En effet, par l'ensemble intégrateur, le relais contrôlant le contact interrupteur correspondant maintient alors ouvert ce dernier.

Intervenant avantageusement ainsi au lieu et place d'un simple fusible, ce contact interrupteur, et le relais qui le pilote, permettent très simplement d'opérer en toute sécurité, sans risque d'une quelconque disjonction.

Il est conjointement prévu un moyen de signalisation, par exemple un simple ronfleur, sur le circuit d'alimentation duquel est également interposé un interrupteur contrôlé, avec, sur le circuit de base de cet interrupteur contrôlé, un comparateur, dont une des entrées est reliée au circuit de contrôle de continuité de masse, et dont l'autre entrée reçoit une tension de référence.

Ainsi, ce moyen de signalisation, qui n'est pas excité dans le cas où une tension alternative est présente sur la masse métallique contrôlée, se trouve excité, dans le cas contraire, si la résistance de terre de cette masse métallique est inférieure à une valeur donnée.

Comme précédemment, l'appareil de contrôle suivant l'invention permet donc avantageusement de réaliser très simplement le contrôle de cette résistance de terre.

Les caractéristiques et avantages de l'invention ressortiront d'ailleurs de la description qui va suivre, à titre d'exemple, en référence aux dessins schématiques annexés sur lesquels :

la figure 1 est un bloc diagramme illustrant le mode d'intervention de l'appareil de contrôle suivant l'invention ;
la figure 2 est une vue en plan de cet appareil de contrôle, vu de dessus ;
la figure 3 en est une vue partielle de bout, suivant la flèche III de la figure 2 ;
la figure 4 en est une autre vue partielle en plan, vu de dessous, suivant la flèche IV de la figure 3 ;
les figures 5 et 6 sont des schémas se rapportant chacun respectivement à deux des circuits que comporte l'appareil de contrôle suivant l'invention.

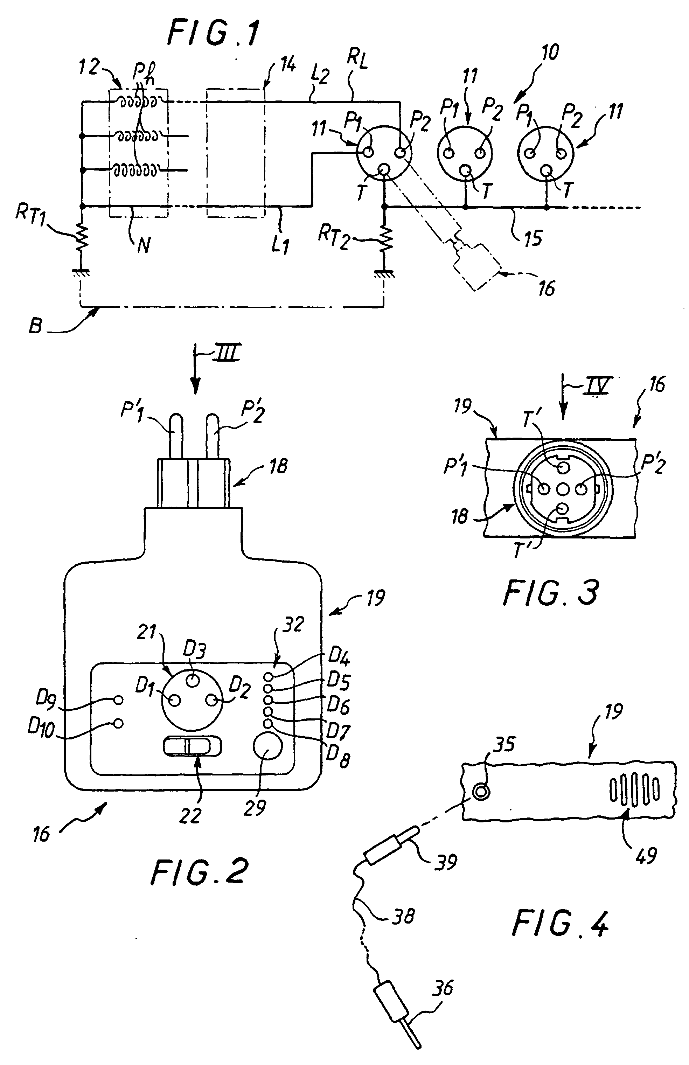

Tel qu'illustré sur la figure 1, il s'agit, globalement, d'assurer le contrôle d'une installation électrique 10 comportant un ou plusieurs socles de prise de courant 11.

De manière usuelle, chacun de ces socles de prise de courant 11 comporte deux contacts de pôle P1, P2 et un contact de terre T.

Les contacts de pôle P1, P2 sont usuellement des alvéoles, tandis que le contact de terre T est par exemple une broche.

L'un des contacts de pôle P1, P2 est câblé par une ligne L2 sur l'une des phases Ph du réseau de distribution électrique 12 disposé en amont.

Il s'agit normalement du contact de pôle P2 qui, géométriquement, se situe sur la droite sur un socle de prise de courant 11.

L'autre des contacts de pôle P1, P2 est câblé par une ligne L1 au neutre N du réseau de distribution électrique 12.

Il s'agit normalement du contact de pôle P1 qui, géométriquement, se situe sur la gauche d'un socle de prise de courant 11.

En amont de chacun des socles de prise de courant 11, et tel que schématisé en traits interrompus pour l'un d'eux sur la figure 1, les lignes L1, L2 traversent un dispositif de protection différentielle 14.

De manière usuelle, le neutre N du réseau de distribution électrique 12 est relié à la terre.

Soit $R_{T1}$ la résistance de terre correspondante.

Corollairement, le contact de terre T de chacun des socles de prise de courant 11 est lui-même relié à la terre, par l'intermédiaire d'un conducteur de protection 15, qui est par exemple commun à l'ensemble de l'installation électrique 10, et qui peut également être relié au neutre N du réseau de distribution électrique 12.

Soit $R_{T2}$ la résistance de terre correspondante.

Il s'agit de la résistance de terre recherchée.

Comme l'appareil de contrôle décrit dans la demande de brevet français No 92 12906, l'appareil de contrôle 16 suivant l'invention comporte des organes de connexion P'1, P'2, T' propres à son branchement sur les contacts de pôle P1, P2 et de terre T d'un socle de prise de courant 11.

Plus précisément, ces organes de connexion P'1, P'2, T' sont des contacts complémentaires de ceux P1, P2, T du socle de prise de courant 11, et ils appartiennent conjointement à une fiche 18 propre à être embrochée sur un tel socle de prise de courant 11.

Plus précisément, encore, la fiche 18 est solidaire du boîtier 19 de l'appareil de contrôle 16 suivant l'invention, en formant avec ce boîtier 19 un ensemble monobloc.

Pour permettre indifféremment une mise en oeuvre dans un sens ou dans l'autre de l'appareil de contrôle 16 suivant l'invention, deux organes de connexion T' sont prévus, en croix avec les organes de connexion P'1, P'2.

En pratique, les organes de connexion P'1, P'2 sont des broches, et les organe de connexion T' sont des alvéoles.

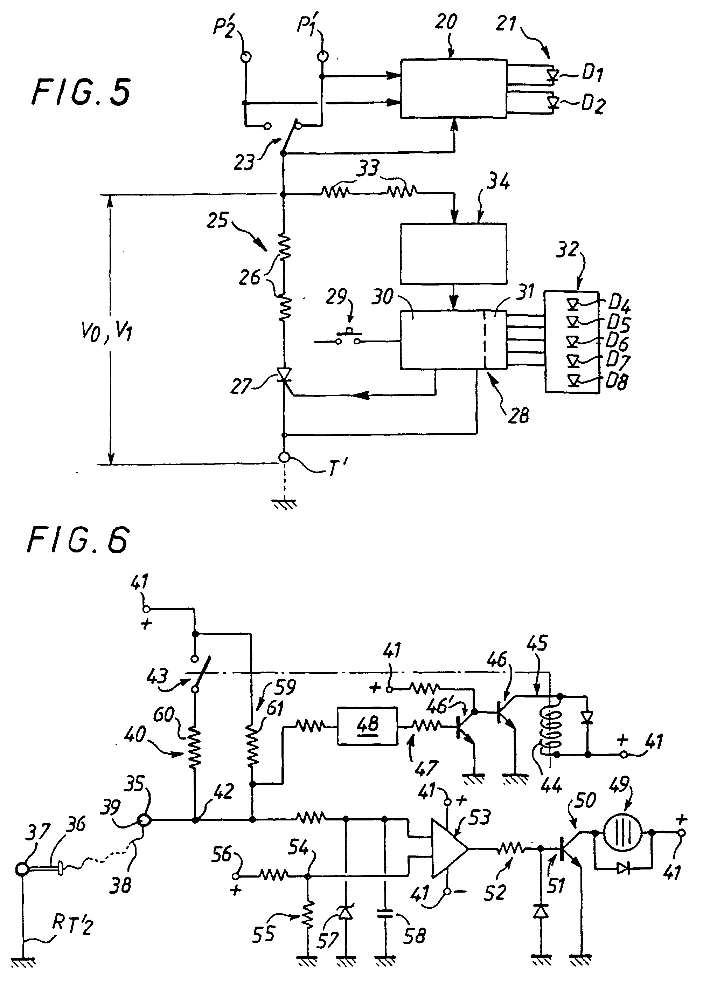

Comme l'appareil de contrôle décrit dans la demande de brevet français No 92 12906, et tel que schématisé à la figure 5, l'appareil de contrôle 16 suivant l'invention comporte au moins un dispositif de détection 20 propre à localiser la phase Ph du réseau de distribution électrique 12, et un dispositif indicateur de phase 21, qui, sous le contrôle de ce dispositif de détection 20, est propre, lui, à situer géométriquement cette phase Ph par rapport aux contacts de pôle P1, P2 du socle de prise de courant 11 contrôlé.

Dans le cas où un seul dispositif de détection 20 est prévu, un inverseur 22 est à la disposition de l'usager, pour la localisation de la phase Ph.

Cet inverseur 22 commande notamment un contact d'inversion 23 intervenant en aval des organes de connexion P'1, P'2.

Quoi qu'il en soit, le dispositif indicateur de phase 21 comporte, globalement, deux organes de visualisation D1, D2, qui interviennent en façade sur le boîtier 19, et qui, en pratique, sont des diodes électroluminescentes de couleur rouge.

Dès l'embrochage de l'appareil de contrôle 16 dans un socle de prise de courant 11, celui des organes de visualisation D1, D2 qui est relié à l'organe de connexion P'1, P'2 correspondant au contact de pôle P2 de ce socle de prise de courant 11 se trouve excité.

. Il s'agit normalement, si l'inverseur 22 est positionné en conséquence, et si le câblage du socle de prise de courant 11 contrôlé est correct, de l'organe de visualisation D2 situé à droite dans le dispositif indicateur de phase 21.

S'il n'en est pas ainsi, l'opérateur modifie la position de l'inverseur 22.

Mais, en toute hypothèse, le dispositif indicateur de phase 21 permet de situer géométriquement à vue la phase Ph par rapport aux contacts de pôle P1, P2 du socle de prise de courant 11 contrôlé.

Dans la forme de réalisation représentée, il est associé, à ce dispositif indicateur de phase 21, un organe de visualisation D3, pour un contrôle conjoint du bon raccordement à la terre du contact de terre T correspondant.

Comme précédemment, cet organe de visualisation D3 est constitué par une diode électroluminescente, par exemple de couleur verte.

Comme l'appareil de contrôle décrit dans la demande de brevet français No 92 12906, l'appareil de contrôle 16 suivant l'invention comporte, en aval du contact d'inversion 23, des moyens de pontage 25, qui sont propres à établir temporairement une liaison entre celui de ses organes de connexion P'1, P'2 qui correspond au contact de pôle P2 du socle de prise de courant 11 relié à la phase Ph et celui de ses organes de connexion T' qui correspond au contact de terre T de ce socle de prise de courant 11.

Dans la forme de réalisation représentée, ces moyens de pontage 25 comportent, en série, deux résistance 26, pour la limitation du courant, et un interrupteur contrôlé 27, en l'espèce un thyristor, pour le contrôle de la liaison correspondante.

Comme l'appareil de contrôle décrit dans la demande de brevet français No 92 12906, l'appareil de contrôle 16 suivant l'invention comporte, enfin, un dispositif de contrôle 28, qui, sous l'action d'un organe de commande 29 à la disposition de l'usager, est apte à envoyer une impulsion de contrôle à travers les moyens de pontage 25.

L'organe de commande 29, qui intervient par exemple en façade du boîtier 19, est par exemple un simple bouton-poussoir ou une touche sensitive.

Les dispositions qui précèdent étant bien connues par elles-mêmes, elles ne seront pas décrites plus en détail ici.

Suivant l'invention, l'impulsion de contrôle délivrée par le dispositif de contrôle 28 est une impulsion de courant I, et ce dispositif de contrôle 28 comporte, d'une part, des moyens de calcul 30, qui sont aptes à mesurer successivement la tension à vide $V_0$ et la tension en charge $V_1$ aux bornes des moyens de pontage 25 et à en déduire une valeur de résistance $R_B$, et, d'autre part, des moyens de comparaison 31, qui, pour la desserte de moyens de signalisation 32 détaillés ultérieurement, sont aptes à comparer la valeur de résistance $R_B$ ainsi calculée à au moins une valeur de résistance donnée précalibrée.

Il s'avère, en effet, que, du fait de l'embrochage de l'appareil de contrôle 16 sur le socle de prise de courant 11 à contrôler, et tel que schématisé en traits interrompus sur la figure 1, les moyens de pontage 25 de cet appareil de contrôle 16 referment sur elle-même une boucle de défaut B faisant successivement intervenir, du contact de terre T de ce socle de prise de courant 11 à son contact de pôle P2 correspondant à la phase Ph du réseau de distribution électrique 12, la résistance de terre $R_{T2}$ recherchée, la résistance de terre $R_{T1}$ de ce réseau de distribution électrique 12 et la résistance de ligne $R_L$ de la ligne L2 concernée.

Les autres résistances en cause étant en pratique négligeables, la valeur de résistance $R_B$ calculée donne une valeur par excès de la résistance de terre $R_{T2}$ recherchée.

La tension à vide $V_0$ étant mesurée en l'absence de l'impulsion de courant I, et la tension en charge $V_1$ en présence de cette impulsion de courant I, la valeur de résistance $R_B$ est en pratique donnée par l'équation suivante :

$$R_B = \frac{V_0 - V_1}{I}$$

En pratique, les tensions $V_0$ et $V_1$ à mesurer sont appliquées au dispositif de contrôle 28 par l'intermédiaire de résistances de limitation de courant 33 et d'un circuit de mise en forme 34.

Ce circuit de mise en forme 34, qui fait par exemple intervenir des monostables, relève de l'homme de l'art, et il ne sera donc pas décrit ici.

Il en est de même pour les moyens de calcul 30 et les moyens de comparaison 31 que comporte le dispositif de contrôle 28, l'ensemble pouvant très simplement être constitué par un microcontrôleur approprié.

En pratique, la mesure de la tension à vide $V_0$ intervient dès l'embrochage de l'appareil de contrôle 16 sur le socle de prise de courant 11 à contrôler.

Cette mesure, qui est mise en mémoire, se fait sur plusieurs alternances et est dûment moyennée.

De même, la mesure de la tension en charge $V_1$, qui intervient après action sur l'organe de commande 29, se fait sur plusieurs alternances correspondant à la durée, dûment calibrée, de l'impulsion de courant I, et elle est elle aussi dûment moyennée.

Préférentiellement, il est fait en sorte que l'impulsion de courant I ne soit pas en mesure de déclencher le dispositif de protection différentielle 14.

Par exemple, cette impulsion de courant I est limitée en amplitude à une valeur au plus égale à la moitié du seuil de sensibilité de ce dispositif de protection différentielle 14.

Dans la forme de réalisation représentée, les moyens de signalisation 32 comportent plusieurs organes de visualisation D4, D5 etc. correspondant chacun respectivement à des valeurs de résistance données précalibrées différentes.

Par exemple, et tel que représenté, cinq organes de visualisation D4, D5, D6, D7, D8 sont prévus, et il s'agit de diodes électroluminescentes, par exemple rouges, alignées en façade du boîtier 19, au-dessus de l'organe de commande 29.

Les valeurs de résistance données précalibrées correspondantes croissent parallèlement par paliers, d'une valeur inférieure, qui est par exemple égale à 5 ohms, pour l'organe de visualisation D4, à une valeur supérieure, qui est par exemple égale à 100 ohms, pour l'organe de visualisation D8.

A chaque contrôle, seul l'un des organes de visualisation D4, D5 etc. est excité, et, comme indiqué ci-dessus, il indique de lui-même une valeur de résistance qui correspond par excès à la résistance de terre $R_{T2}$ recherchée.

Dans la forme de réalisation représentée, l'appareil de contrôle 16 suivant l'invention comporte, en outre, au dos de son boîtier 19, un organe de connexion auxiliaire 35 propre au branchement d'une pointe de touche 36, en vue du contrôle d'une quelconque masse métallique 37 éventuellement présente dans le local dans lequel intervient l'installation électrique 10.

Par exemple, et tel que représenté, cet organe de connexion auxiliaire 35 est un alvéole, et la pointe de touche 36 est disposée en bout d'un cordon 38 à l'autre extrémité duquel est prévue une fiche 39 complémentaire de l'organe de connexion auxiliaire 35.

Tel qu'illustré sur la figure 6, cet organe de connexion auxiliaire 35 est relié à un circuit de contrôle de continuité de masse 40 intervenant entre une source de tension continue 41, de 8 volts par exemple, et la terre.

Plus précisément, l'organe de connexion auxiliaire 35 est relié à un point milieu 42 du circuit de contrôle de continuité de masse 40.

Sur ce circuit de contrôle de continuité de masse 40, et, plus précisément, sur la partie de celui-ci intervenant en amont du point milieu 42, est interposé un contact interrupteur 43 piloté par un relais 44 sur le circuit d'alimentation 45 duquel est interposé un interrupteur contrôlé 46, et sur le circuit de commande 47 de cet interrupteur contrôlé 46 intervient un ensemble intégrateur 48 dont l'entrée est reliée à l'organe de connexion auxiliaire 35.

En pratique, l'interrupteur contrôlé 46 est un simple transistor, sur le circuit de commande, c'est-à-dire de base, 47, duquel intervient, en cascade, en aval de l'ensemble intégrateur 48, un autre transistor 46'.

La réalisation de l'ensemble intégrateur 48 relevant de l'homme de l'art, elle ne sera pas décrite ici.

Corollairement, il est prévu un moyen de signalisation 49, par exemple un ronfleur, sur le circuit d'alimentation 50 duquel est interposé un interrupteur contrôlé 51, en pratique un simple transistor, avec, intervenant sur le circuit de commande, c'est-à-dire de base, 52, de cet interrupteur contrôlé 51, un comparateur 53, dont une des entrées est reliée au circuit de contrôle de continuité de masse 40, et, plus précisément, à la partie de celui-ci s'étendant en aval du point milieu 42, et dont l'autre entrée, reliée au point milieu 54 d'un pont diviseur 55 établi entre une source de tension continue 56, de 5 volts par exemple, et la terre, reçoit ainsi une tension de référence.

En pratique, à l'entrée du comparateur 53, le circuit de contrôle de continuité de masse 40 est soumis à une diode Zener 57, pour écrêtage de la tension dont il peut être le siège, et un condensateur 58, pour filtrage de cette tension.

Dans la forme de réalisation représentée, sur le contact interrupteur 43 interposé sur le circuit de contrôle de continuité de masse 40 est établi en dérivation un circuit de polarisation 59 sur lequel est branché l'ensemble intégrateur 48, ce qui permet la polarisation convenable de l'ensemble même lorsque ce contact interrupteur 43 est ouvert.

Sur la partie du circuit de contrôle de continuité de masse 40 contrôlée par le contact interrupteur 43 intervient une résistance 60 de relativement faible valeur, de l'ordre de 33 ohms par exemple, tandis que, sur le circuit de polarisation 59, intervient une résistance 61 de valeur au contraire très élevée, de l'ordre de 330 kiloohms par exemple.

Lorsque, l'appareil de contrôle 16 étant dûment embroché dans un socle de prise de courant 11, la pointe de touche 36, elle-même dûment branchée par la fiche 39 de son cordon 38 sur l'organe de connexion auxiliaire 35 de cet appareil de contrôle 16, est amenée au contact de la masse métallique 37 à contrôler, tel que représenté sur la figure 6, deux cas sont à considérer.

Si cette masse métallique 37 n'est pas correctement raccordée à la terre, et est le siège d'une tension alternative susceptible d'être dangereuse, cette tension alternative, dûment détectée par l'ensemble intégrateur 48, provoque le blocage de l'interrupteur contrôlé 46, ce qui interdit l'alimentation du relais 44.

Dûment ouvert, le contact interrupteur 43 met hors service le circuit de contrôle de continuité de masse 40.

L'interrupteur contrôlé 51 est lui-même bloqué, et le moyen de signalisation 49 n'est donc pas excité.

L'absence, donc, d'émission de la part de ce moyen de signalisation 49 signale, dans ce cas, que la masse métallique 37 n'est pas correctement raccordée à la terre.

Si, au contraire, et tel que représenté, cette masse métallique 37 est correctement raccordée à la terre, suivant une résistance de terre $R_{T'2}$, l'interrupteur contrôlé 46 est passant, en sorte que, dûment excité, le relais 44 provoque la fermeture du contact interrupteur 43.

Ainsi mis en service, le circuit de contrôle de continuité de masse 40 provoque l'injection d'une impulsion de courant I' dans la boucle qui s'établit par la terre entre la masse métallique 37 et la partie de ce circuit de contrôle de continuité de masse 40 située en amont de son point milieu 42.

La tension alors détectée par le comparateur 53 provoque, si elle est suffisante, c'est-à-dire si la résistance de terre $R_{T'2}$ est suffisamment faible, le déblocage de l'interrupteur contrôlé 51, et, donc, l'excitation du moyen de signalisation 49.

Ainsi, l'émission d'un signal par ce moyen de signalisation 49 indique, dans ce cas, que la masse métallique 37 contrôlée est correctement raccordée à la terre, et que la résistance de terre $R_{T'2}$ correspondante est inférieure à une valeur donnée, de l'ordre par exemple de 3 ohms.

Suivant les dispositions normatives en la matière, l'impulsion de courant I' nécessaire à un tel contrôle est de l'ordre de 200 milliampères, sous une tension comprise entre 4 et 24 volts.

Dans la forme de réalisation représentée, l'appareil de contrôle 16 suivant l'invention comporte, encore, en façade, deux organes de visualisation D9, D10, par exemple de simples diodes électroluminescentes de couleur rouge, qui correspondent chacun respectivement à deux niveaux de tension différents, et qui permettent de savoir à quel niveau se situe la tension de la phase Ph détectée.

L'un de ces niveaux de tension correspond par exemple à 220 volts, et l'autre à 380 volts.

Les circuits correspondant à la desserte de ces deux organes de visualisation D9, D10 relevant de l'homme de l'art, ils ne seront pas décrits ici.

Bien entendu, la présente invention ne se limite pas à la forme de réalisation décrite et représentée, mais englobe toute variante d'exécution telle que définie dans les revendications suivantes.

## Revendications

1. Appareil de contrôle pour socle de prise de courant à contact de terre, du genre comportant des organes de connexion (P'1, P'2, T'), qui sont propres à son branchement sur les contacts de pôle (P1, P2) et de terre (T) du socle de prise de courant (11) à contrôler, des moyens de pontage (25), qui sont propres à établir une liaison entre celui de ces organes de connexion (P'1, P'2) qui correspond au contact de pôle (P1, P2) du socle de prise de courant (11) relié à la phase et celui de ces organes de connexion (T') qui correspond au contact de terre (T) de celui-ci, et un dispositif de contrôle (28), qui, sous l'action d'un organe de commande (29) à la disposition de l'usager, est apte à envoyer une impulsion de contrôle à travers lesdits moyens de pontage (25), **caractérisé en ce que**, l'impulsion de contrôle étant une impulsion de courant (I) appliquée aux bornes des moyens de pontage (25), le dispositif de contrôle (28) comporte, d'une part, des moyens de calcul (30), qui sont aptes à mesurer successivement la tension à vide ($V_0$) et la tension en charge ($V_1$) aux bornes des moyens de pontage (25) et à en déduire une valeur de résistance ($R_B$), et, d'autre part, des moyens de comparaison (31), qui, pour la desserte de moyens de signalisation (32), sont aptes à comparer la valeur de résistance ($R_B$) ainsi calculée à plusieurs valeurs de résistance données précalibrées différentes, les moyens de signalisation (32) comportant plusieurs organes de visualisation (D4, D5, D6, D7, D8) correspondant chacun respectivement à l'une desdites valeurs de résistance données précalibrées différentes.

2. Appareil de contrôle suivant la revendication 1, **caractérisé en ce qu'**il comporte en outre un organe de connexion auxiliaire (35), qui, propre au branchement d'une pointe de touche (36), est relié à un circuit de contrôle de continuité de masse (40), avec, interposé sur ce circuit de contrôle de continuité de masse (40), un contact interrupteur (43) piloté par un relais (44) sur le circuit d'alimentation (45) duquel est interposé un interrupteur contrôlé (46), et **en ce que**, sur le circuit de commande (47) de cet interrupteur contrôlé (46), intervient un ensemble intégrateur (48) dont l'entrée est reliée à l'organe de connexion auxiliaire (35).

3. Appareil de contrôle suivant la revendication 2, **caractérisé en ce qu'**il comporte également un moyen de signalisation (49) sur le circuit d'alimentation (50) duquel est interposé un interrupteur contrôlé (51), avec, intervenant sur le circuit de commande (52) de cet interrupteur contrôlé (51), un comparateur (53) dont une des entrées est reliée au circuit de contrôle de continuité de masse (40) et dont l'autre entrée reçoit une tension de référence.

4. Appareil de contrôle suivant l'une quelconque des revendications 2 ou 3, **caractérisé en ce que**, sur le contact interrupteur (43) interposé sur le circuit de contrôle de continuité de masse (40), est établi en dérivation un circuit de polarisation (59) sur lequel est branché l'ensemble intégrateur (48).

## Patentansprüche

1. Testgerät für eine geerdete Steckdose bzw. Wandsteckdose der Art, umfassend Verbindungs- bzw. Anschlußorgane (P'1, P'2, T'), welche für einen Zweiganschluß auf den Kontakten der Pole (P1, P2) und der Erde (T) der zu testenden Steckdose (11) geeignet sind, Überbrückungsmittel (25), welche geeignet sind, eine Verbindung zwischen denjenigen der Anschlußorgane (P'1, P'2), welche dem Polkontakt (P1, P2) der mit der Phase verbundenen Steckdose (11) entsprechen, und jenem der Anschlußorgane (T) geeignet sind, welcher dem Erdkontakt (T) davon entspricht, und eine Steuer- bzw. Regelanordnung bzw. Testanordnung (28), welche unter der Wirkung eines dem Benutzer zur Verfügung stehenden Steuerorgans (29) fähig ist, einen Test- bzw. Kontrollimpuls über die Überbrückungsmittel (25) auszusenden, **dadurch gekennzeichnet, daß** der Testimpuls ein Stromimpuls (I) ist, welcher an die Anschlußklemmen der Überbrückungsmittel (25) angelegt ist, die Steuer- bzw. Regel- bzw. Testvorrichtung (28) einerseits Berechnungsmittel (30), welche fähig bzw. geeignet sind, aufeinanderfolgend die offene Spannung ($V_0$) und die Ladespannung ($V_1$) an den Klemmen der Überbrückungsmittel (25) zu messen und daraus einen Widerstand ($R_B$) abzuleiTrägerelementen, und andererseits Vergleichsmittel (31) umfaßt, welche zur Erschließung bzw. Bereitstellung von Signalisiermitteln (32) fähig sind, den so berechneten Widerstandswert ($R_B$) mit mehreren gegebenen vorkalibrierten unterschiedlichen Widerstandswerten zu vergleichen, wobei die Signalisier- bzw. Anzeigemittel (32) mehrere Organe zur Sichtbarmachung (D4, D5, D6, D7, D8) umfassen, die jeweils einem der gegebenen vorkalibrierten unterschiedlichen Widerstandwerte entsprechen.

**2.** Testgerät nach Anspruch 1, **dadurch gekennzeichnet, daß** es außerdem ein hilfsweises bzw. Hilfsverbindungsorgan (35) umfaßt, welches zur Verzweigung von einem Berührungspunkt (36) geeignet, mit einer Schaltung zum Kontrollieren bzw. Testen der Kontinuität der Masse (40) verbunden ist, wobei auf dieser Testschaltung der Kontinuität der Masse (40) ein Unterbrecherkontakt (43) zwischengeschaltet ist, der durch ein Relais (44) auf der Speiseschaltung bzw. Zufuhrschaltung (45) gesteuert ist, auf welcher ein gesteuerter bzw. geregelter Testunterbrecher (46) zwischengeschaltet ist, und daß auf der Steuerschaltung (47) des gesteuerten bzw. geregelten Testunterbrechers (46) ein Integrator bzw. eine Integratoranordnung (48) eingreift, dessen (deren) Eingang mit dem Hilfsverbindungsorgan (35) verbunden ist.

**3.** Testgerät nach Anspruch 2, **dadurch gekennzeichnet, daß** es außerdem ein Signalisier- bzw. Sichtbarmachungsmittel (49) auf der Speiseschaltung (50) umfaßt, auf welcher ein gesteuerter bzw. geregelter Testunterbrecher (51) zwischengelagert ist, wobei auf dieser Steuer- bzw. Regelschaltung (52) gesteuerten bzw. geregelten bzw. Testunterbrechers (51) ein Komparator (53) zwischengeschaltet ist, dessen Eingänge mit der Testschaltung der Kontinuität der Masse (40) verbunden ist und dessen anderer Eingang eine Referenz- bzw. Bezugsspannung erhält.

**4.** Testgerät nach einem der Ansprüche 2 oder 3, **dadurch gekennzeichnet, daß** auf dem Unterbrecherkontakt (43), der auf der Testschaltung der Kontinuität der Masse (40) zwischengelagert ist, in Ableitung bzw. Abwandlung eine Polarisationsschaltung (59) eingerichtet ist, auf welcher der Integrator (48) angeordnet bzw. abgezweigt ist.

**Claims**

**1.** Test device for socket outlets with an earth contact, the device comprising connection members (P'1, P'2, T') adapted to connect it to the pole contacts (P1, P2) and to the earth contact (T) of the socket outlet (11) to be tested, bridging means (25) adapted to make a connection between the connection member (P'1, P'2) that corresponds to the live pole contact (P1, P2) of the socket outlet (11) and the connection member (T') that corresponds to the earth contact (T) thereof, and a test device (28) which, when actuated by an actuator member (29) accessible to the user, sends a test pulse through said bridging means (25), which test device is **characterized in that**, the test pulse being a current pulse (I) applied to the terminals of the bridging means (25), the test device (28) comprises, firstly, calculation means (30) adapted to measure successively the no-load voltage ($V_0$) and the load voltage ($V_1$) at the terminals of the bridging means (25) and to deduce therefrom a resistance value ($R_B$) and, secondly, comparison means (31) adapted to compare the calculated resistance value ($R_B$) with a plurality of different precalibrated given resistance values and connected to signaling means (32) comprising a plurality of display members (D4, D5, D6, D7, D8) each corresponding to a respective one of said different precalibrated given resistance values.

**2.** Test device according to claim 1, **characterized in that** it further comprises an auxiliary connection member (35) adapted to connect a probe (36) and connected to an earth continuity test circuit (40) which includes a switch contact (43) actuated by a relay (44) whose energization circuit (45) includes a controlled switch (46) and a test circuit (47) of the controlled switch (46) includes an integrator (48) whose input is connected to the auxiliary connection member (35).

**3.** Test device according to claim 2, **characterized in that** it also comprises signaling means (49) whose supply circuit (50) includes a controlled switch (51) and a comparator (53) in the actuation circuit (52) of the controlled switch (51) having one input connected to the earth continuity test circuit (40) and another input adapted to receive a reference voltage.

**4.** Test device according to either claim 2 or claim 3, **characterized in that** a bias circuit (59) to which the integrator assembly (48) is connected is connected to the switch contact (43) in the earth continuity test circuit (40).

EP 0 715 172 B1

FIG.1

FIG.2

FIG.3

FIG.4

9

FIG.5

FIG.6